# FASCICULE DE BREVET EUROPEEN

(11) **EP 3 484 039 B1**
(45) Date de publication et mention de la délivrance du brevet: **30.12.2020**
(21) Numéro de dépôt: 18204745.6
(22) Date de dépôt: 06.11.2018
(51) Int. Cl.: H02M 7/487, H02M 1/44, H02M 7/00, H05K 7/14, H01L 25/07, H01L 25/11, H01L 23/538

(54) **MODULE DE COMMUTATION POUR ONDULEUR OU REDRESSEUR DE TENSION**
SCHALTMODUL FÜR SPANNUNGSWECHSEL- ODER GLEICHRICHTER
SWITCHING MODULE FOR INVERTER OR VOLTAGE RECTIFIER

(30) Priorité: 10.11.2017 FR 1760577
(43) Date de publication de la demande: 15.05.2019
(73) Titulaire: Commissariat à l'Energie Atomique et aux Energies Alternatives, 75015 Paris (FR)
(72) Inventeur: LEFEVRE, Guillaume, 73100 Aix Les Bains (FR)
(74) Mandataire: Cabinet Beaumont

(56) Documents cités:
- EP-A1- 2 884 650
- EP-A1- 2 996 233
- EP-A2- 0 590 502

## Description

### Domaine

La présente description concerne de façon générale les circuits électroniques et, plus particulièrement, les convertisseurs ou onduleurs de tension. La présente description s'applique plus particulièrement aux convertisseurs ou onduleurs de tension utilisant des modules de commutation basés sur des composants semiconducteurs et à la topologie de montage de tels composants.

### État de l'art antérieur

Les convertisseurs ou onduleurs de tension sont largement utilisés en électronique de puissance ou électrotechnique, pour transférer l'énergie dans des convertisseurs d'énergie. On connait de nombreuses applications dans lesquelles un ou plusieurs onduleurs de tension, réalisant une conversion continu-alternatif (dc-ac), sont utilisés dans des systèmes de conversion dont la fonction de conversion globale est quelconque (dc-dc, ac-ac, dc-ac ou ac-dc).

Une catégorie de convertisseurs particulièrement répandue concerne les onduleurs à point neutre pincé ou clampé (NPC - Neutral Point Clamped). Typiquement, un onduleur de tension de ce type est basé sur l'utilisation de modules de commutation constitués de commutateurs de puissance, généralement des transistors MOS ou des transistors IGBT, montés avec des éléments capacitifs.

Les différents composants et leur montage sont choisis en fonction du niveau de la tension (plusieurs centaines de volts, voire de l'ordre du millier ou de quelques milliers de volts).

Le document EP 2 884 650 décrit un module de puissance à deux éléments et un dispositif de conversion de puissance à trois niveaux, basé sur la réplication de ce module. Chaque module comporte deux transistors MOS connectés en série au niveau du drain de l'un et de la source de l'autre. Les modules sont réalisés séparément pour être agencés en 3D, un module étant superposé sur les deux autres modules.

Le document EP 2 996 233 décrit un dispositif semiconducteur comportant deux circuits de commutation respectivement sur des IGBT et des diodes.

Le document EP 0 590 502 décrit un appareil inverseur pour matériel roulant électrique.

### Résumé

Un mode de réalisation pallie tout ou partie des inconvénients des modules de commutation pour convertisseur ou onduleur de tension connus.

Un mode de réalisation propose une solution particulièrement adaptée à des tensions de plusieurs centaines à quelques milliers de volts.

Un mode de réalisation propose une solution particulièrement adaptée à minimiser les pertes en conduction dans le module de commutation.

Ainsi, un mode de réalisation prévoit un module de commutation multiniveaux à point neutre clampé, comme spécifiée par la revendication 1.

Selon un mode de réalisation, lesdits deux commutateurs sont agencés pour, lorsqu'ils sont traversés par un même courant, compenser mutuellement leurs inductances parasites respectives.

Selon un mode de réalisation, le module est réalisé sur au moins une plaquette de circuit imprimé définissant des zones conductrices de réception de composants et de fils de reprise de contact.

Selon un mode de réalisation, des premières faces des commutateurs et diodes sont coplanaires.

Selon un mode de réalisation, quatre zones conductrices portent chacune un des commutateurs.

Selon un mode de réalisation, le module comporte deux plaquettes coplanaires recevant respectivement au moins les premier et deuxième commutateurs et les troisième et quatrième commutateurs, chaque plaquette comportant une zone conductrice de définition d'un des noeuds de connexion d'une des diodes.

Selon un mode de réalisation, chaque commutateur est associé à une diode montée en parallèle.

Selon un mode de réalisation, les commutateurs sont des composants semiconducteurs, de préférence des transistors MOS ou IGBT.

Selon un mode de réalisation, chaque diode montée en parallèle d'un commutateur est la diode intrinsèque du transistor.

Selon un mode de réalisation, chaque commutateur est constitué de plusieurs puces semiconductrices électriquement en parallèle.

Un mode de réalisation prévoit un convertisseur d'énergie comportant :
au moins un module de commutation ; et
au moins un pont diviseur capacitif.

Selon un mode de réalisation, le pont diviseur capacitif comporte deux éléments capacitifs en série entre les bornes d'entrée, un noeud entre les deux éléments capacitifs étant relié à la deuxième borne de sortie.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique, le schéma électrique d'un exemple usuel de module de commutation simple niveau, associé à un diviseur capacitif, pour convertisseur ou onduleur ;
la figure 2 représente, de façon très schématique, le schéma électrique d'un exemple de module de commutation multiniveaux associé à un diviseur capacitif pour convertisseur à point neutre clampé (NPC) ;
la figure 3 représente un schéma électrique d'un mode de réalisation d'un module de commutation à point neutre clampé associé à un pont diviseur capacitif ;
la figure 4 est une vue en coupe très schématique d'une puce en matériau semiconducteur, formant une diode ;
la figure 5 est une vue en coupe très schématique d'une puce en matériau semiconducteur, formant un transistor MOS vertical ;
la figure 6 est une vue de dessus d'un mode de réalisation d'un module de commutation selon le schéma de la figure 3 ;
la figure 7 est une vue de dessus d'un autre mode de réalisation d'un module de commutation du type de celui illustré par la figure 6 ; et
la figure 8 est une vue de dessus d'encore un autre mode de réalisation d'un module de commutation selon le schéma de la figure 3.

### Description détaillée

De mêmes éléments ont été désignés par de mêmes références aux différentes figures.

Par souci de clarté, seuls les étapes et éléments utiles à la compréhension des modes de réalisation qui vont être décrits ont été représentés et seront détaillés. En particulier, les applications des modes de réalisation des modules de commutation décrits n'ont pas été détaillées, les modes de réalisation décrits étant compatibles avec les applications usuelles de tels modules de commutation quelle que soit la conversion finalement réalisée par le système de conversion d'énergie. En particulier, ce qui est décrit en relation avec un onduleur de tension se transpose à un redresseur de tension. De même, les signaux de commande des différents commutateurs ne sont pas détaillés, la génération de ces signaux dépend de l'application et les structures proposées dans la présente description sont compatibles avec les circuits de commande usuels.

Sauf précision contraire, lorsque l'on fait référence à deux éléments connectés entre eux, cela signifie directement connectés sans élément intermédiaire autre que des conducteurs, et lorsque l'on fait référence à deux éléments couplés ou reliés entre eux, cela signifie que ces deux éléments peuvent être directement reliés (connectés) ou reliés par l'intermédiaire d'un ou plusieurs autres éléments.

Dans la description qui suit, lorsque l'on fait référence aux termes « approximativement », « environ » et « de l'ordre de », cela signifie à 10 % près, de préférence à 5 % près.

Dans la description qui suit, lorsque l'on fait référence à des qualificatifs de position absolue, tels que les termes "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures.

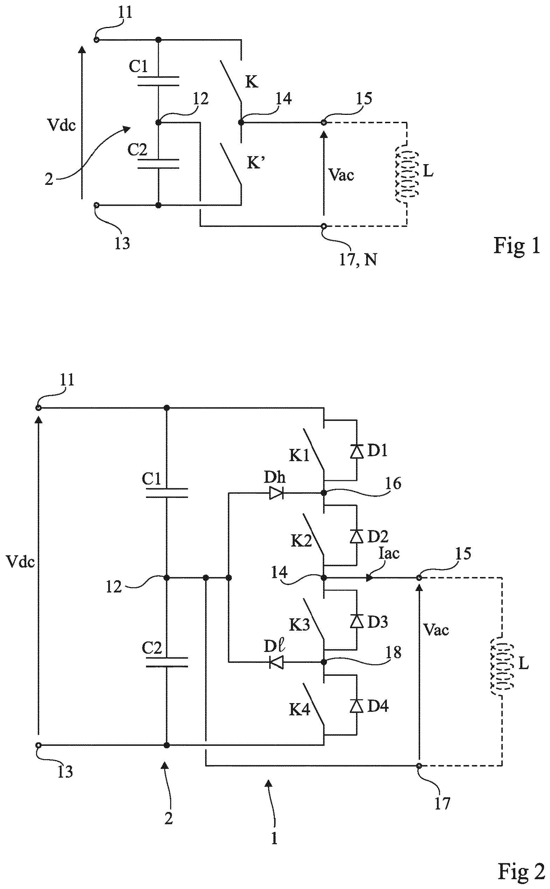

La figure 1 représente, de façon très schématique, le schéma électrique d'un exemple usuel de module de commutation simple niveau, associé à un pont diviseur capacitif, pour convertisseur ou onduleur.

Le module de commutation comporte deux bornes d'entrée 11 et 13 destinées à recevoir une tension continue Vdc et deux bornes de sortie 15 et 17 destinées à fournir une tension alternative Vac. Le module de commutation comporte deux commutateurs K et K' en série, reliant (de préférence connectant) les bornes 11 et 13. Le point milieu 14 entre les commutateurs K et K' définit la borne 15.

Deux éléments capacitifs C1 et C2 en série, formant un diviseur capacitif 2, relient (de préférence connectent) les bornes 11 et 13. Le point milieu 12 du diviseur capacitif (entre les éléments capacitifs C1 et C2) définit le point milieu de l'onduleur et, dans l'exemple de la figure 1, le neutre N de la tension alternative Vac. Généralement, la borne 15 est connectée à une charge inductive L représentée en pointillés en figure 1 (par exemple, l'enroulement d'un moteur ou l'inductance de filtrage d'une charge ou d'un autre étage de conversion).

Le fonctionnement d'un convertisseur tel que représenté en figure 1 est connu. La tension alternative est générée en commandant séquentiellement les commutateurs K et K' selon une séquence de phases successives dans lesquelles les deux commutateurs K et K' sont ouverts, seul le commutateur K est fermé, les deux commutateurs K et K' sont ouverts, seul le commutateur K' est fermé, et ainsi de suite. Chaque élément capacitif C1, C2 voit, à ses bornes, une tension dont la valeur correspond à la moitié de la valeur de la tension Vdc. La tension de sortie Vac oscille alors entre -Vdc/2 et Vdc/2. Pour simplifier l'exposé de la figure 1, les différents éléments parasites (tels que notamment les inductances parasites des conducteurs reliant les éléments capacitifs aux commutateurs), bien que jouant un rôle dans le fonctionnement, n'ont pas été représentés.

En pratique, les commutateurs sont réalisés par des composants semiconducteurs, typiquement des transistors MOS de puissance ou des transistors IGBT. En raison des niveaux de tension en jeu, qui peuvent aller jusqu'à plusieurs milliers de volts, les pertes en conduction et lors des commutations dans les transistors peuvent devenir non négligeables. Afin de réduire ces pertes, on utilise fréquemment des structures dites multiniveaux permettant de réduire la tension aux bornes des commutateurs, pour utiliser des commutateurs à tenue en tension plus faible et réduire ainsi les pertes globales.

La figure 2 représente, de façon très schématique, le schéma-électrique d'un exemple de module 1 de commutation multiniveaux associé à un diviseur capacitif 2 pour convertisseur à point neutre clampé (NPC).

Comme en figure 1, le diviseur capacitif 2 comporte deux éléments capacitifs C1 et C2 en série entre deux bornes d'entrée 11 et 13 du module de commutation.

Le module de commutation 1 est formé de quatre commutateurs K1, K2, K3 et K4, en série entre les deux bornes 11 et 13 d'entrée destinées à recevoir une tension continue Vdc à convertir. Les commutateurs sont associés deux à deux, chaque paire constituant un demi-étage, respectivement haut ou bas de l'association en série. Le point milieu 14 entre les deux demi-étages définit la première borne 15 de sortie de fourniture d'une tension alternative Vac, la deuxième borne 17 de la tension Vac étant le neutre connecté, dans cet exemple, au noeud 12. Chaque paire de commutateurs est associée à une diode Dh, respectivement Dl, dont une électrode (la cathode pour la diode Dh et l'anode pour la diode Dl) est connectée au point milieu 16, respectivement 18, de l'association en série des deux commutateurs K1, K2, respectivement K3, K4, du demi-étage. L'autre électrode des diodes Dh et Dl (l'anode pour la diode Dh et la cathode pour la diode Dl) est reliée (de préférence connectée) au point milieu 12 de l'association en série des éléments capacitifs C1 et C2 du diviseur capacitif 2. Enfin, chaque commutateur K1, K2, K3, K4 est pourvu d'une diode D1, D2, D3, D4 en antiparallèle constituant une association en série de diodes entre les bornes 11 et 13, toutes les anodes étant dirigées côté borne 13. Les diodes D1 à D4 sont en pratique constituées des diodes intrinsèques des transistors, de préférence dans ce cas des transistors MOS, formant les commutateurs K1 à K4.

Le plus souvent, la charge connectée à la borne 15 (entre les bornes 15 et 17) est, au moins partiellement, inductive (inductance L représentée en pointillés) et capacitive. Avec une commande appropriée des commutateurs K1 à K4, la tension Vac est alors sinusoïdale. Les commutateurs K1 à K4 sont typiquement commandés en modulation de largeur d'impulsions en fonction, entre autres, de la fréquence de la tension alternative souhaitée et de la quantité d'énergie devant être transférée à la charge. La fréquence des impulsions de commande est généralement supérieure dans un rapport d'au moins dix, à la fréquence de la tension alternative Vac.

Le fonctionnement d'un onduleur tel qu'illustré en figure 2 requiert plus de phases de commutation que celui de la figure 1, mais réduit les pertes notamment car, pour une tension continue donnée, il requiert des transistors de tenue en tension (état bloqué) plus faible, engendrant donc moins de pertes résistives à l'état passant et qui sont plus performants en commutation. La tension de sortie du module, dans le cas de la figure 2 prend, selon la phase de commutation (sans considérer la transformation vers une forme d'onde alternative due à la charge), les valeurs de Vdc, Vdc/2, 0, -Vdc/2, et -Vdc.

Les phases de commutations dépendent des signes positifs ou négatifs de la tension ou du courant de sortie. Comme la charge est, au moins partiellement, inductive, la tension Vac et le courant Iac ne sont généralement pas en phase. Par convention, on considère le courant Iac positif quand il sort de la borne 15 vers la charge.

Les boucles de commutation dans le module de commutation 1 sont conditionnées par la commande des commutateurs K1 à K4, qui dépend du signe de la tension Vac par rapport au noeud 12-17 et du sens du courant Iac.

Quand la tension Vac et le courant Iac sont positifs (phase I), le commutateur K2 est commandé pour être fermé (passant). Le commutateur K4 est ouvert (bloqué). Le commutateur K3 est commandé de manière complémentaire au commutateur K1. Le courant Iac circule :
- Quand le commutateur K1 est fermé, depuis la borne 11, à travers les commutateurs K1 et K2, jusqu'à la borne 15 ; et
- Quand le commutateur K1 est ouvert, depuis la borne 12, à travers la diode Dh et le commutateur K2.

Quand la tension Vac et le courant Iac sont négatifs (phase III), le commutateur K3 est commandé pour être fermé (passant). Le commutateur K1 est ouvert (bloqué). Le commutateur K2 est commandé de manière complémentaire au commutateur K4. Le courant Iac circule :
- Quand le commutateur K4 est fermé, depuis la borne 15 à travers les commutateurs K3 et K4, jusqu'à la borne 13 ; et
- Quand le commutateur K4 est ouvert, depuis la borne 15, à travers le commutateur K3 et la diode Dl.

Quand la tension Vac est positive et le courant Iac est négatif (phase II), le commutateur K2 est commandé pour être fermé (passant). Le commutateur K4 est ouvert (bloqué). Le commutateur K1 est commandé de manière complémentaire au commutateur K3. Le courant Iac circule :
- Quand le commutateur K3 est ouvert, depuis la borne 15 à travers les diodes D1 et D2, jusqu'à la borne 11 ; et
- Quand le commutateur K3 est fermé, depuis la borne 15, à travers le commutateur K3 et la diode Dl.

Quand la tension Vac est négative et le courant Iac est positif (phase IV), le commutateur K3 est commandé pour être fermé (passant). Le commutateur K1 est ouvert (bloqué). Le commutateur K4 est commandé de manière complémentaire au commutateur K2. Le courant Iac circule :
- Quand le commutateur K2 est ouvert, depuis la borne 13 à travers les diodes D3 et D4, jusqu'à la borne 15 ; et
- Quand le commutateur K2 est fermé, depuis la borne 12, à travers la diode Dh et le commutateur K2.

Un inconvénient des structures usuelles de modules de commutation à point milieu capacitif est que les boucles de circulation du courant ne sont pas symétriques (de même longueur) dans toutes les phases. On désigne généralement les phases I et III qui n'impliquent que deux composants semiconducteurs pour la commutation (respectivement commutateur K1 et diode Dh, et commutateur K4 et diode Dl) comme boucles courtes et les phases II et IV qui impliquent quatre composants semiconducteurs (respectivement commutateur K3 et diodes D1, D2, Dl, et commutateur K2 et diodes D3, D4, Dh) comme boucles longues.

Cette différence de longueur de boucle engendre des différences non négligeables dans les chemins inductifs. Il n'est pas rare de trouver des modules de commutation dans lesquels les chemins inductifs engendrent des inductances parasites de l'ordre de la vingtaine de nanohenrys voire plus pour les boucles de courant courtes et de l'ordre de la trentaine de nanohenrys pour les boucles de courant longues. L'écart est alors de l'ordre de cinquante pour cent entre boucles longues et boucles courtes. Cela impose de dimensionner l'ensemble du module en fonction du pire cas, c'est-à-dire du pire chemin inductif et d'en tenir compte dans la programmation des commutations. Il en résulte en général une fréquence de commutation plus lente des commutateurs, et des pertes plus élevées.

On a déjà proposé des structures symétriques à point milieu capacitif et point neutre clampé en respectant un fonctionnement à trois niveaux (Vdc, Vdc/2, 0). Toutefois, ces structures, connues sous la désignation à point neutre clampé en T (T-NPC ou T-type Neutral Point Clamped) requièrent de dimensionner deux des quatre commutateurs pour qu'ils supportent toute l'amplitude de la tension Vdc, ce qui ramène des inconvénients de la structure à deux niveaux de figure 1.

Toutes ces difficultés se trouvent accrues par le fait que, si du point de vue schéma électrique sur papier, un montage peut être symétrique, ce n'est pas le cas lors de la réalisation industrielle de ce montage sous forme de puces de composants semiconducteurs montés sur un substrat ou plaquette et connectés par pistes conductrices ou par fils conducteurs.

Les modes de réalisation ci-dessous tirent leur origine d'une nouvelle analyse du fonctionnement d'un module de commutation NPC à trois niveaux pour symétriser les chemins électriques des différentes phases de commutation tout en conservant des composants n'ayant besoin de tenir que la moitié de l'amplitude de la tension continue d'entrée.

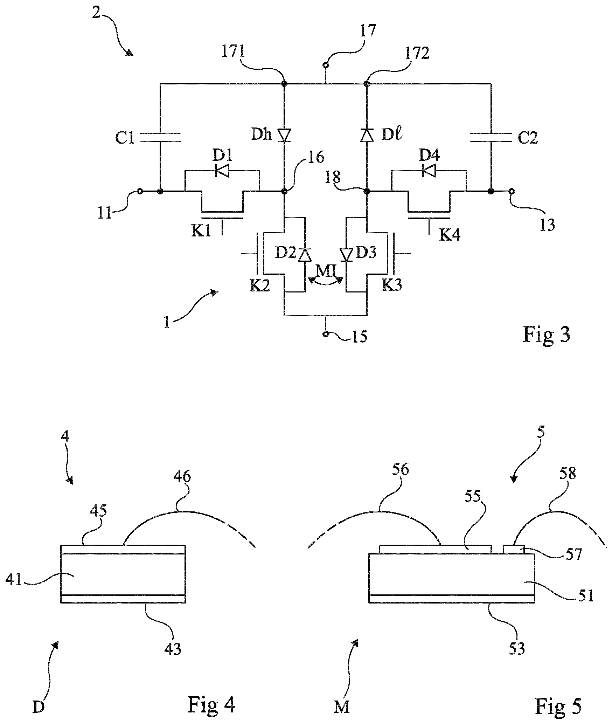

La figure 3 représente un schéma électrique d'un mode de réalisation d'un module de commutation 1 à point neutre clampé associé à un pont diviseur capacitif 2.

On retrouve les mêmes composants que dans le montage de la figure 2, à savoir :
- Deux éléments capacitifs C1 et C2 en série entre des bornes 11 et 13 d'application d'une tension continue ;
- Deux commutateurs commandables K1 et K2, ici des transistors MOS, en série entre la borne 11 et une première borne 15 de fourniture d'une tension alternative, le point milieu 16 de cette association en série étant relié, par une diode Dh (cathode côté noeud 16), à une deuxième borne 17 de fourniture de la tension alternative (neutre), également reliée au point milieu 12 entre les éléments capacitifs C1 et C2 ;
- Deux commutateurs commandables K3 et K4, en série entre les bornes 15 et 13, le point milieu 18 de cette association en série étant relié, par une diode Dl (anode côté noeud 18), à la borne 17 ; et
- Quatre diodes D1, D2, D3 et D4 en série entre les bornes 11 et 13, les anodes étant toutes dirigées vers la borne 13 et les diodes D1 à D4 étant de préférence les diodes intrinsèques de transistors K1 à K4.

Toutefois, d'un point de vue tracé ou chemins électriques, on prévoit de disposer les différents composants afin d'équilibrer les chemins inductifs entre les boucles longues et les boucles courtes. On aurait pu penser allonger les longueurs des chemins des boucles courtes pour les faire correspondre à celles des boucles longues. Toutefois, cela ne changerait pas la situation classique dans la mesure où cela reviendrait à un dimensionnement au pire cas. Ainsi, dans les modes de réalisation ci-dessous, on prévoit non seulement de réduire le trajet inductif des boucles courtes, mais également de réduire les résultantes des valeurs d'inductance des trajets des boucles longues afin de les rapprocher de celles des boucles courtes.

Pendant la phase I, la boucle de courant inclut le commutateur K1 et la diode Dh.

Pendant la phase II, la boucle de courant inclut les commutateurs K1, K2, K3 et la diode Dl.

Pendant la phase III, la boucle de courant inclut la diode Dl et le commutateur K4.

Pendant la phase IV, la boucle de courant inclut la diode Dh et les commutateurs K2, K3 et K4.

La représentation de la figure 3 fait ressortir une disposition particulière du montage des composants semiconducteurs sur un substrat ou sur une plaquette de circuit imprimé. En effet, les commutateurs K2 et K3 sont disposés l'un à côté de l'autre et avec des courants qui les traversent ayant des sens opposés. Ainsi, l'inductance qui est apportée par chaque composant K2 et K3 est compensée par celle de l'autre en raison de la mutuelle inductance MI entre les deux chemins qui sont à proximité l'un de l'autre et dans lesquels les courants sont en sens inverses. Par conséquent, du point de vue du trajet inductif, on peut ne pas tenir compte des commutateurs K2 et K3 qui se compensent partiellement et considérer que le nombre de composants est le même dans les boucles longues et dans les boucles courtes. La structure devient alors symétrique, tout en conservant l'avantage de pertes réduites par le fait que les différents composants ne voient au maximum que la moitié de la tension Vdc. Ainsi, lors du montage des commutateurs en module, on prévoit que le trajet électrique dans les quatre commutateurs décrive approximativement une forme de T, deux des commutateurs situés au milieu de l'association en série étant disposés dans le pied du T. Ces deux commutateurs sont agencés pour, lorsqu'ils sont traversés par un même courant, compenser mutuellement leurs inductances parasites respectives.

Une telle association en T sur un substrat ou un circuit imprimé conduit à une disposition des composants sur un même plan. Cette disposition en plan, dans laquelle les commutateurs du module de commutation sont coplanaires (des premières faces des commutateurs et diodes sont coplanaires), participe à l'équilibre des boucles de courant entre les différentes phases de commutation.

Selon l'invention revendiquée, on prévoit de dissocier physiquement un noeud 171 de connexion de l'anode de la diode Dh à l'élément capacitif C1 d'un noeud 172 de connexion de la cathode de la diode Dl à l'élément capacitif C2. Cette nouvelle structure permet de séparer au mieux les boucles de courant les unes des autres et, comme on le verra par la suite, facilite la réalisation industrielle avec des chemins approximativement symétriques.

La réalisation d'un module de commutation à base de composants semiconducteurs fait généralement appel à des composants de puissance verticaux, c'est-à-dire à des puces semiconductrices dont une face arrière comporte un plan métallique destiné à être directement monté sur une surface conductrice d'un substrat ou plaquette du module, et dont une face avant comporte une (pour une diode) ou deux (pour un commutateur) métallisations pour recevoir, par soudure, un ou plusieurs fils conducteurs de report du contact vers une zone conductrice du substrat ou plaquette.

Les modes de réalisation décrits ci-dessous visent ce type de réalisations.

La figure 4 est une vue en coupe très schématique d'une puce 4 en matériau semiconducteur, formant une diode D.

La diode D est formée, par exemple, dans un substrat 41 de type N. Une métallisation face arrière 43 définit la cathode de la diode. Une région de type P est formée en face avant et est contactée par une métallisation 45 définissant l'anode. La puce 4 est destinée à être montée par sa face arrière sur une zone conductrice d'une plaquette (non représentée en figure 4) supportant le module de commutation. L'anode 45 est destinée à être ramenée sur une zone conductrice de la plaquette ou en face avant d'un autre composant par un ou plusieurs fils conducteurs 46.

La figure 5 est une vue en coupe très schématique d'une puce 5 en matériau semiconducteur, formant un transistor MOS vertical M.

On suppose la réalisation d'un transistor à canal P dans un substrat 51 de type N, dont le drain est défini par la face arrière (métallisation 53). Les contacts de source sont repris en face avant par une ou plusieurs métallisations 55 et la grille est également accessible par une métallisation 57 en face avant. La puce 5 est destinée à être montée par sa face arrière (drain) sur une zone conductrice d'une plaquette (non représentée en figure 5) supportant le module de commutation. La source 55 et la grille 57 sont destinées à être ramenées sur une zone conductrice de la plaquette ou en face avant d'un autre composant par un ou plusieurs fils conducteurs, respectivement 56 et 58.

Pour réaliser un module de puissance, plusieurs puces 4 et 5 peuvent être utilisées pour réaliser chaque diode D et chaque commutateur M en montant et connectant ces puces en parallèle, en fonction de la puissance requise. De même, les éléments capacitifs C1 et C2 peuvent être constitués d'un ou plusieurs condensateurs connectés en parallèle.

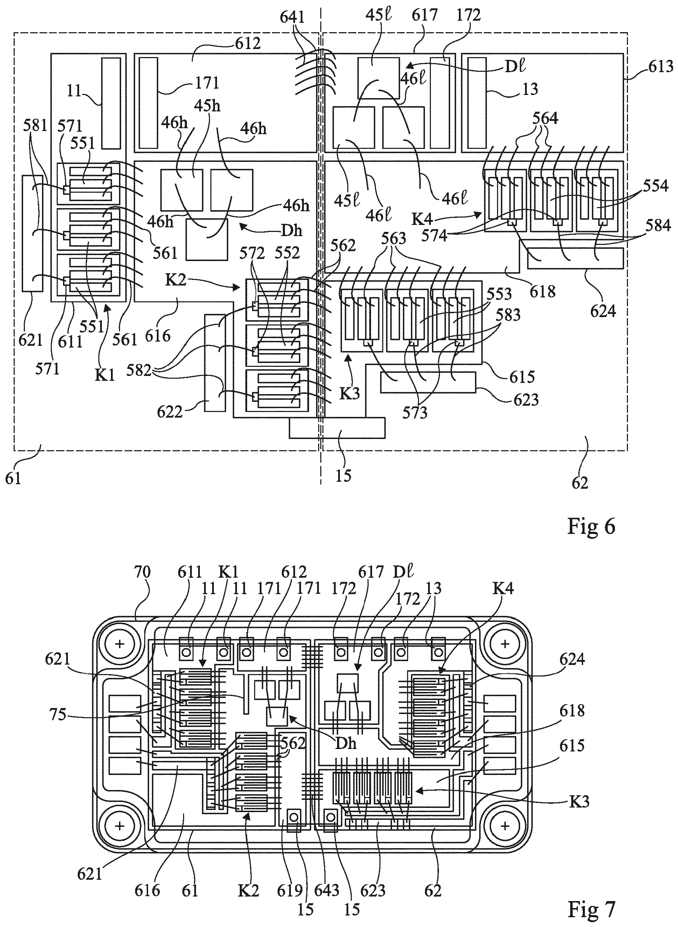

La figure 6 est une vue de dessus d'un mode de réalisation d'un module de commutation selon le schéma de la figure 3.

L'ensemble est réalisé sur deux plaquettes 61 et 62 distinctes l'une de l'autre. Chaque plaquette est par exemple réalisée sur un substrat métallique isolé ou un circuit imprimé (PCB - Printed Circuit Board) et comporte des zones et surfaces conductrices séparées, c'est-à-dire isolées les unes des autres.

Dans l'exemple de la figure 6, on suppose la réalisation d'un module dans lequel chaque commutateur est constitué de trois puces 5 de transistor MOS (figure 5) et chaque diode Dh, Dl, est constituée de trois puces 4 (figure 4). On suppose également que les diodes D1, D2, D3 et D4 sont constituées des diodes intrinsèques des transistors K1, K2, K3 et K4.

Chaque plaquette 61, 62 porte une moitié du montage de la figure 3, c'est-à-dire respectivement les composants Dh, K1, K2 et les composants Dl, K3, K4. Ces composants sont répartis en suivant la disposition en T de la figure 3 et en tenant compte de contraintes liées à l'encombrement. La séparation entre les plaquettes représente la séparation entre les noeuds 171 et 172 afin de forcer la circulation du courant dans la partie du montage définissant les transistors K2 et K3 et bénéficier de l'effet de mutuelle inductance.

On prévoit de définir, dans chaque plaquette 61, 62, plusieurs zones conductrices en circuit imprimé pour porter les contacts de face arrière des composants, recevoir les fils de reprise de contacts de face avant, ainsi que des zones d'entrée et sortie. Les composants, et notamment les transistors K1 et K2 sont, de préférence, tous portés par la même face des plaquettes qui sont disposées de façon coplanaire. Cela participe à uniformiser la longueur des boucles de courant.

Côté plaquette 61, on prévoit dans cet exemple cinq zones conductrices. Une zone 621, par exemple de forme générale rectangulaire orientée verticalement, située la plus à gauche, définit une borne du montage de réception du signal de commande de grille du transistor K1. A droite de la zone 621, une zone 611, par exemple de forme générale rectangulaire orientée verticalement, reçoit les faces arrière des puces constituant les transistors K1, donc la borne 11. A droite de la partie inférieure de la zone 611, se trouve une zone 616, par exemple en forme générale de L renversé, dont la base (en haut) porte les puces constituant la diode Dh par leurs faces arrière de cathode, donc le noeud 16. La branche verticale du L de la zone 616 est dirigée vers le bas (respectant la forme du montage de la figure 3) et reçoit les faces arrière (drains) des puces constituant le transistor K2. A droite de la partie supérieure de la zone 611, se trouve une zone 612, par exemple de forme générale rectangulaire orientée horizontalement (le long de la base du L de la zone 616). La zone 612 définit une première borne 171 du neutre 17 (ou noeud 12). A gauche de la branche du L de la zone 616 se trouve une zone 622, par exemple de forme générale rectangulaire orientée verticalement, définissant une borne de réception du signal de commande de grille du transistor K2. Les reports des contacts de face avant des différentes puces sur les zones conductrices sont effectués par des fils conducteurs soudés ou brasés (à chaud ou à froid) . Ainsi, des fils 581 connectent des contacts 571 de grille des puces définissant le transistor K1 à la zone 621. Des fils 561 connectent des contacts 551 de source des puces définissant le transistor K1 à la zone 616. Des fils 582 connectent des contacts 572 de grille des puces définissant le transistor K2 à la zone 622. Des fils 46h connectent des contacts d'anode 45h des puces définissant la diode Dh à la zone 612.

Côté plaquette 62, on prévoit dans cet exemple six zones conductrices. Une zone 617, par exemple de forme générale carrée ou rectangulaire orientée horizontalement, est située en regard de la zone 612 de la plaquette 61. Cette zone 617 définit une deuxième borne 172 du neutre 17 (noeud 12) et reçoit les puces constituant la diode Dl par leurs faces arrière de cathode. Des fils 641 relient les zones 612 et 617. A droite de la zone 617, une zone 613, par exemple de forme générale carrée ou rectangulaire orientée horizontalement, définit la borne 13. Sous les zones 617 et 613, une zone 618, par exemple de forme générale rectangulaire orientée horizontalement, reçoit en partie droite les faces arrière des puces constituant les transistors K4, donc le noeud 18. Une zone 615, par exemple de forme générale rectangulaire ou en L se situe sous la partie gauche de la zone 618 et en regard de la branche de la zone 616 recevant le transistor K1. Cette zone 615 reçoit les faces arrière des puces constituant les transistors K3, donc la borne 15. Une zone 623, par exemple de forme générale rectangulaire orientée horizontalement, définit sous la zone 615 une borne du montage de réception du signal de commande de grille du transistor K3. Enfin, une zone 624, par exemple de forme générale rectangulaire orientée horizontalement, définit sous la partie droite (libre) de la zone 618 une borne du montage de réception du signal de commande de grille du transistor K4. Des fils 583 connectent les contacts 573 de grille des puces définissant le transistor K3 à la zone 623. Des fils 564 connectent les contacts 554 de source des puces définissant le transistor K4 à la zone 613. Des fils 584 connectent les contacts 574 de grille des puces définissant le transistor K4 à la zone 624. Des fils 46l connectent les contacts d'anode 45l des puces définissant la diode Dl à la zone 617. Enfin, des fils 562 connectent les contacts 552 de source des puces définissant le transistor K2 à la zone 615. La borne 15 est, dans cet exemple, prise sur la zone 615.

Une structure telle qu'illustrée en figure 6 respecte le schéma de la figure 3 en séparant les noeuds de neutre des partie gauche et droite de la structure, de façon à optimiser la symétrie des chemins inductifs.

La figure 7 est une vue de dessus d'un mode de réalisation d'un module de commutation du type de celui illustré par la figure 6.

On suppose l'ensemble monté dans un boîtier 70. Les différentes zones conductrices des plaquettes 61 et 62 sont définies pour s'inscrire dans des plaquettes rectangulaires ou carrées. Ainsi, les formes données pour exemple en figure 6 ne sont pas respectées. Toutefois, ces formes sont dessinées et disposées de façon à respecter des chemins inductifs approximativement symétriques dans les différentes boucles. Par exemple, par rapport à la figure 6, on prévoit quatre puces pour réaliser chaque commutateur. Par ailleurs, les puces formant le transistor K4 sont disposées verticalement au lieu de horizontalement comme en figure 6. En pratique, on prévoit en périphérie du module des borniers de raccordement du module de commutation au pont capacitif et à la charge. Ainsi, les zones 621 et 623 en particulier sont prolongées par un tracé jusqu'à des borniers respectivement à gauche et à droite du module. De plus, on prévoit, côté plaquette 61, une zone supplémentaire 619 de réception des fils 562 de reprise des sources des puces constituant le transistor K2. Cette zone 619 est reliée par des fils 643 à la zone 615 de la plaquette 62. Un avantage est que cela facilite la fabrication des parties gauche et droite du module de façon séparée, la connexion des deux noeuds 171 et 172 de neutre et le raccordement côté borne 15 s'effectuant ultérieurement.

Le cas échéant, on peut prévoir qu'une ou plusieurs zones conductrices aient une fente (par exemple la fente verticale 75 dans la zone 616) afin d'orienter la circulation du courant ou d'obliger un certain trajet. Cela permet d'optimiser encore la symétrie des chemins inductifs.

De préférence, les puces, dont les contacts de face avant qui doivent être rapportés sur une zone conductrice voisine, sont orientées de façon que les fils de connexion ou de pontage (wire bonding) aient tous approximativement une même longueur pour des puces données du même composant. Cela permet de ne pas introduire un nouveau déséquilibre dans la longueur des trajets conducteurs.

Un module tel que représenté en figure 7 peut être réalisé avec des valeurs d'inductance de chemins inductifs de l'ordre de la dizaine de nanohenrys et avec un écart de valeur d'inductance entre les chemins inductifs de moins de 20 pour cent, voire de l'ordre de 10 pour cent, de la valeur moyenne de l'inductance des chemins inductifs. Ainsi, non seulement l'agencement prévu permet de réduire la valeur de l'inductance des chemins inductifs des différentes boucles d'un facteur de l'ordre de 2 ou 3 par rapport aux agencements usuels, mais également, notamment grâce à l'agencement des commutateurs K2 et K3, l'écart d'inductance entre les boucles longues et courtes est considérablement réduit.

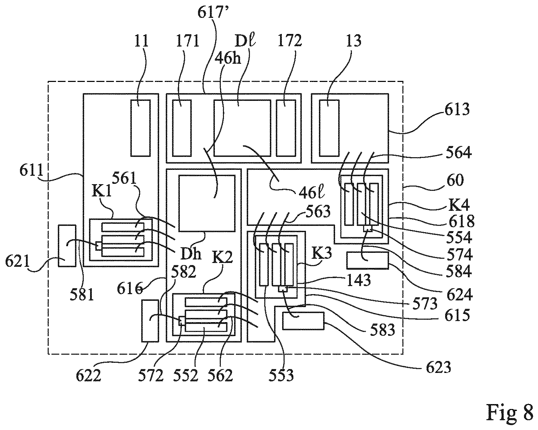

La figure 8 est une vue de dessus d'encore un autre mode de réalisation d'un module de commutation selon le schéma de la figure 3.

Ce mode de réalisation est simplifié en ce sens qu'il ne prévoit qu'une puce par composant. Par ailleurs, le module est réalisé sur une seule plaquette de circuit imprimé. Une conséquence est qu'une seule zone 617' définit le noeud de neutre 17.

Un avantage des modes de réalisation décrits est qu'ils combinent la possibilité d'utiliser des composants semiconducteurs dimensionnés pour une tension inférieure à la tension d'un convertisseur à deux niveaux (figure 1) tout en autorisant un équilibrage des chemins inductifs dans les différentes boucles de circulation du courant.

Un module de commutation multiniveaux n'est pas nécessairement utilisé seul. Par exemple, pour réaliser un onduleur de tension Vac sinusoïdale, on utilise plusieurs de ces modules dont le nombre dépend du nombre de phases de la tension alternative générée (deux pour une tension monophasée, trois pour une tension triphasée).

Divers modes de réalisation ont été décrits. Diverses modifications apparaîtront à l'homme de l'art. En particulier, le dimensionnement des composants semiconducteurs dépend de l'application et, notamment, des tensions mises en jeu. Par ailleurs, le nombre de composants en parallèle pour former chaque composant semiconducteur dépend également de l'application et plus précisément de la puissance du module et du courant qu'il doit supporter. En outre, le fonctionnement en redresseur se déduit du fonctionnement en onduleur et tout ce qui a été décrit se transpose sans difficulté à un redresseur de tension. Enfin, la mise en oeuvre pratique des modes de réalisation qui ont été décrits est à la portée de l'homme du métier en utilisant les indications fonctionnelles données ci-dessus.

## Revendications

1. Module de commutation multiniveaux à point neutre clampé de structure coplanaire, comportant un premier, un deuxième, un troisième et un quatrième commutateurs (K1, K2, K3, K4) en série connectés entre deux bornes (11, 13) d'entrée du module, dans lequel
le trajet électrique dans les quatre commutateurs décrit approximativement une forme de T, les deuxième (K2) et troisième (K3) commutateurs, situés au milieu de l'association en série, étant disposés dans le pied du T ;
chacun desdits deuxième et troisième commutateurs (K2, K3) est en série avec une diode (Dh, Dl) entre une première borne de sortie (15) définie par un noeud entre lesdits deuxième et troisième commutateurs (K2, K3) et une deuxième borne de sortie (17) du module, les diodes (Dh, Dl) étant connectées à des noeuds (171, 172) distincts, interconnectés symétriquement à la deuxième borne de sortie (17), avec un premier noeud (171) connecté à la première desdites diodes (Dh), le premier noeud (171) comportant une borne de connexion pour un premier élément capacitif (C1), et un deuxième noeud (172) connecté à la deuxième desdites diodes (Dl), le deuxième noeud (172) comportant une borne de connexion pour un deuxième élément capacitif (C2) ;
un noeud (16) entre le premier commutateur (K1) et le deuxième commutateur (K2) est relié, par la première diode (Dh), à la deuxième borne de sortie (17) ;
un noeud (18) entre le troisième commutateur (K3) et le quatrième commutateur (K4) est relié, par la deuxième diode (Dl), à la deuxième borne de sortie (17).

2. Module selon la revendication 1, dans lequel lesdits deux commutateurs (K2, K3) sont agencés pour, lorsqu'ils sont traversés par un même courant, compenser mutuellement (MI) leurs inductances parasites respectives.

3. Module selon la revendication 1 ou 2, réalisé sur au moins une plaquette (60 ; 61, 62) de circuit imprimé définissant des zones conductrices de réception de composants et de fils de reprise de contact.

4. Module selon la revendication 3, dans lequel des premières faces des commutateurs (K1, K2, K3, K4) et diodes (Dh, Dl) sont coplanaires.

5. Module selon la revendication 4, dans lequel quatre zones conductrices (611, 616, 615, 618) portent chacune un des commutateurs (K1, K2, K3, K4).

6. Module selon la revendication 5, dans son rattachement à la revendication 3, comportant deux plaquettes (61, 62) coplanaires recevant respectivement au moins les premier et deuxième commutateurs (K1, K2) et les troisième et quatrième commutateurs (K3, K4), chaque plaquette comportant une zone conductrice (612, 617) de définition d'un des noeuds (171, 172) de connexion d'une des diodes (Dh, Dl).

7. Module selon l'une quelconque des revendications 1 à 6, dans lequel chaque commutateur (K1, K2, K3, K4) est associé à une diode (D1, D2, D3, D4) montée en parallèle.

8. Module selon l'une quelconque des revendications 1 à 7, dans lequel les commutateurs (K1, K2, K3, K4) sont des composants semiconducteurs, de préférence des transistors MOS ou IGBT.

9. Module selon les revendications 7 et 8, dans lequel chaque diode (D1, D2, D3, D4) montée en parallèle d'un commutateur (K1, K2, K3, K4) est la diode intrinsèque du transistor.

10. Module selon l'une quelconque des revendications 1 à 9, dans lequel chaque commutateur (K1, K2, K3, K4) est constitué de plusieurs puces semiconductrices électriquement en parallèle.

11. Convertisseur d'énergie comportant :
au moins un module de commutation (1) selon l'une quelconque des revendications 1 à 10 ; et
au moins un pont diviseur capacitif (C1, C2).

12. Convertisseur selon la revendication 11, dans lequel le pont diviseur capacitif comporte deux éléments capacitifs (C1, C2) en série entre les bornes d'entrée (11, 13), un noeud (12) entre les deux éléments capacitifs étant relié à la deuxième borne de sortie (15).

## Patentansprüche

1. Sternpunktgeklemmtes Mehrebenen-Schaltmodul mit einer koplanaren Struktur, die einen ersten, einen zweiten, einen dritten und einen vierten in Reihe geschalteten Schalter (K1, K2, K3, K4) zwischen zwei Eingangsanschlüssen (11, 13) des Moduls aufweist, wobei
der elektrische Pfad in den vier Schaltern ungefähr einer T-Form entspricht, wobei der zweite (K2) und der dritte (K3) Schalter, die sich in der Mitte der Reihenanordnung befinden, im Fuß des T angeordnet sind;
jeder der zweiten und dritten Schalter (K2, K3) mit einer Diode (Dh, Dl) zwischen einem ersten Ausgangsanschluss (15), der durch einen Knoten zwischen den zweiten und dritten Schaltern (K2, K3) definiert ist, und einem zweiten Ausgangsanschluss (17) des Moduls in Reihe geschaltet ist, wobei die Dioden (Dh, Dl) mit separaten Knoten (171, 172) verbunden sind, die symmetrisch mit dem zweiten Ausgangsanschluss (17) verbunden sind, wobei ein erster Knoten (171) mit der ersten der Dioden (Dh) verbunden ist, wobei der erste Knoten (171) einen Verbindungsanschluss für ein erstes kapazitives Element (C1) aufweist, und wobei ein zweiter Knoten (172) mit der zweiten der Dioden (Dl) verbunden ist, wobei der zweite Knoten (172) einen Verbindungsanschluss für ein zweites kapazitives Element (C2) aufweist;
ein Knoten (16) zwischen dem ersten Schalter (K1) und dem zweiten Schalter (K2) über die erste Diode (Dh) mit einem zweiten Ausgangsanschluss (17) gekoppelt ist;
ein Knoten (18) zwischen dem dritten Schalter (K3) und dem vierten Schalter (K4) über die zweite Diode (Dl) mit dem zweiten Ausgangsanschluss (17) gekoppelt ist.

2. Modul nach Anspruch 1, wobei die beiden Schalter (K2, K3) so angeordnet sind, dass sie, wenn sie den gleichen Strom leiten, ihre jeweiligen parasitären Induktivitäten gegenseitig kompensieren (MI).

3. Modul nach Anspruch 1 oder 2, gebildet auf mindestens einer gedruckten Leiterplatte (60; 61, 62), die leitende Bereiche zur Aufnahme von Komponenten und Leiterbahnen definiert.

4. Modul nach Anspruch 3, wobei die ersten Oberflächen der Schalter (K1, K2, K3, K4) und Dioden (Dh, Dl) koplanar sind.

5. Modul nach Anspruch 4, wobei vier leitende Flächen (611, 616, 615, 618) jeweils einen der Schalter (K1, K2, K3, K4) tragen.

6. Modul nach Anspruch 5 in Abhängigkeit von Anspruch 3, mit zwei koplanaren Leiterplatten (61, 62), die mindestens den ersten und zweiten Schalter (K1, K2) bzw. den dritten und vierten Schalter (K3, K4) aufnehmen, wobei jede Leiterplatte einen leitenden Bereich (612, 617) aufweist, der einen der Verbindungsknoten (171, 172) einer der Dioden (Dh, Dl) definiert.

7. Modul nach einem der Ansprüche 1 bis 6, wobei jeder Schalter (K1, K2, K3, K4) einer parallel geschalteten Diode (D1, D2, D3, D4) zugeordnet ist.

8. Modul nach einem der Ansprüche 1 bis 7, wobei die Schalter (K1, K2, K3, K4) Halbleiterbauelemente, vorzugsweise MOS- oder IGBT-Transistoren, sind.

9. Modul nach den Ansprüchen 7 und 8, wobei jede Diode (D1, D2, D3, D4), die parallel zu einem Schalter (K1, K2, K3, K4) geschaltet ist, die intrinsische Diode des Transistors ist.

10. Modul nach einem der Ansprüche 1 bis 9, wobei jeder Schalter (K1, K2, K3, K4) aus einer Vielzahl von Halbleiterchips gebildet ist, die elektrisch parallel geschaltet sind.

11. Ein Leistungswandler, der Folgendes aufweist::
mindestens ein Schaltmodul (1) nach einem der Ansprüche 1 bis 10; und
mindestens eine kapazitive Teilerbrücke (C1, C2).

12. Wandler nach Anspruch 11, wobei die kapazitive Teilerbrücke zwei kapazitive Elemente (C1, C2) aufweist, die zwischen den Eingangsanschlüssen (11, 13) in Reihe geschaltet sind, wobei ein Knoten (12) zwischen den beiden kapazitiven Elementen mit dem zweiten Ausgangsanschluss (15) verbunden ist.

## Claims

1. A neutral point clamped multiple-level switching unit having a coplanar structure, comprising a first, a second, a third and a fourth series-connected switches (K1, K2, K3, K4) between two input terminals (11, 13) of the module, wherein
the electric path in the four switches approximately follows a T shape, the second (K2) and third (K3) switches located in the middle of the series association being arranged in the foot of the T;
each of said second and third switches (K2, K3) is series-connected with a diode (Dh, Dl) between a first output terminal (15) defined by a node between said second and third switches (K2, K3) and a second output terminal (17) of the unit, the diodes (Dh, Dl) being connected to separate nodes (171, 172), symmetrically interconnected to the second output terminal (17), with a first node (171) connected to the first of said diodes (Dh), the first node (171) comprising a connecting terminal for a first capacitive element (C1), and a second node (172) connected to the second of said diodes (Dl), the second node (172) comprising a connecting terminal for a second capacitive element (C2);
a node (16) between the first switch (K1) and the second switch (K2) is coupled, by the first diode (Dh), to a second output terminal (17);
a node (18) between the third switch (K3) and the fourth switch (K4) is coupled, by the second diode (Dl), to the second output terminal (17).

2. The unit of claim 1, wherein said two switches (K2, K3) are arranged to, when they conduct a same current, mutually compensate (MI) their respective parasitic inductances.

3. The unit of claim 1 or 2, formed on at least one printed circuit wafer (60; 61, 62) defining conductive areas for receiving components and contact transfer wires.

4. The unit of claim 3, wherein first surfaces of the switches (K1, K2, K3, K4) and diodes (Dh, Dl) are coplanar.

5. The unit of claim 4, wherein four conductive areas (611, 616, 615, 618) each support one of the switches (K1, K2, K3, K4).

6. The unit of claim 5 in its dependency of claim 3, comprising two coplanar wafers (61, 62) respectively receiving at least the first and second switches (K1, K2) and the third and fourth switches (K3, K4), each wafer comprising a conductive area (612, 617) defining one of the nodes (171, 172) of connection of one of the diodes (Dh, Dl).

7. The unit of any of claims 1 to 6, wherein each switch (K1, K2, K3, K4) is associated with a diode (D1, D2, D3, D4) assembled in parallel.

8. The unit of any of claims 1 to 7, wherein the switches (K1, K2, K3, K4) are semiconductor components, preferably MOS or IGBT transistors.

9. The unit of claim 7 and 8, wherein each diode (D1, D2, D3, D4) assembled in parallel with a switch (K1, K2, K3, K4) is the intrinsic diode of the transistor.

10. The unit of any of claims 1 to 9, wherein each switch (K1, K2, K3, K4) is formed of a plurality of semiconductor chips electrically in parallel.

11. A power converter comprising:
at least one switching unit (1) of any of claims 1 to 10; and
at least one capacitive dividing bridge (C1, C2).

12. The converter of claim 11, wherein the capacitive dividing bridge comprises two capacitive elements (C1, C2) series-connected between the input terminals (11, 13), a node (12) between the two capacitive elements being coupled to the second output terminal (15).
